# FASCICULE DE BREVET EUROPEEN

(11) **EP 0 336 460 B1**
(45) Date de publication et mention de la délivrance du brevet: **25.05.1994**
(21) Numéro de dépôt: 89200401.1
(22) Date de dépôt: 20.02.1989
(51) Int. Cl.: H03K 3/037, H03K 3/356

(54) **Bascule pour diviser la fréquence par 2**
Kippschaltung zum Teilen der Frequenz durch 2
Flip-flop for frequency division by 2

(30) Priorité: 26.02.1988 FR 8802374
(43) Date de publication de la demande: 11.10.1989
(73) Titulaire: PHILIPS COMPOSANTS, 92150 Suresnes (FR); Philips Electronics N.V., 5621 BA Eindhoven (NL)
(72) Inventeur: Chantepie, Bernard, F-75007 Paris (FR)
(74) Mandataire: Charpail, François

(56) Documents cités:
- CH-A- 524 933
- DD-A- 247 558
- FR-A- 2 362 534
- US-A- 3 649 815
- US-A- 4 112 296
- PATENT ABSTRACTS OF JAPAN, Vol. 5, No. 44 (e-50)(716), 24 mars 1981 & JP - A- 56 747
- PATENT ABSTRACTS OF JAPAN, Vol. 6, No. 107 (E-113)(985), 17 juin 1982; & JP - A - 57 37934
- IEEE ELECTRON DEVICE LETTERS, Vol. EDL-4, No. 10, octobre 1983, pages 377-379; R.A. KIEHL et al.: "Selectively doped heterostructure frequency dividers"

## Description

La présente invention concerne une bascule pour diviser par 2 la fréquence d'un signal appliqué à une borne d'entrée, comprenant d'une part une bascule RS constituée par une première et une deuxième portes logiques dont les premières entrées sont mutuellement intercouplées à leurs sorties, et comprenant d'autre part une troisième et une quatrième portes logiques dont les sorties sont couplées, respectivement aux entrées de la première et de la deuxième portes logiques, dont les premières entrées sont couplées respectivement, à la sortie de la deuxième et de la première portes logiques et dont les deuxièmes entrées sont reliées à ladite borne d'entrée.

L'invention trouve une application particulièrement avantageuse dans le domaine des circuits intégrés numérique LSI.

Une bascule de ce type est connue du document FR-A-2 362 534.

La bascule connue met en oeuvre en plus des quatre portes logiques mentionnées, un inverseur logique dont le temps de retard apporté à la propagation du signal est au moins le double de celui de l'une desdites portes logiques. Par ailleurs, deux des quatre portes logiques sont à trois entrées, de sorte que leur réalisation, dans l'exemple de réalisation indiqué, comporte l'emploi de 6 transistors.

La réalisation indiquée, pour chacune de ces portes à 3 entrées, utilise 6 transistors, alors que l'inverseur logique utilise 4 transistors.

La bascule connue présente l'inconvénient d'une limitation de la fréquence d'utilisation du fait du temps de retard de l'inverseur logique, volontairement prolongé par rapport à celui des portes logiques. Par ailleurs elle nécessite l'emploi d'un nombre relativement élevé de transistors.

Le problème technique très général à résoudre lorsque l'on veut réaliser des circuits numériques devant être intégrés à grande échelle (LSI) est de diminuer le nombre de composants des ensembles assurant une fonction donnée, comme, par exemple, les portes logiques d'une bascule D. Ce résultat doit, de préférence, être obtenu sans altération des performances, et, en particulier, de la dynamique.

Aussi le problème technique à résoudre par l'objet de la présente demande est de proposer une bascule pour diviser par 2 la fréquence d'un signal appliqué à une borne d'entrée, qui serait formée d'un nombre de composants moins élevé que la bascule connue, tout en présentant au moins la même fréquence maximum de fonctionnement et de préférence une fréquence maximum plus élevée.

La solution au problème technique posé consiste, selon la présente invention, en ce que le couplage des premières entrées des troisième et quatrième portes logiques respectivement vers les sorties des deuxième et première portes logiques est effectué via un chemin de conduction d'un premier et d'un second interrupteurs, lesdits interrupteurs étant commandés à partir de la borne d'entrée.

Ainsi, la bascule conforme à l'invention est constituée de 10 transistors et de 4 résistances, ce qui représente une diminution appréciable du nombre de composants. D'autre part, la fréquence maximum de la bascule selon l'invention est égale à Fₘₐₓ = 1/4Tpd, où Tpd est le temps de propagation à travers une porte.

La description qui va suivre en regard du dessin annexé, donné à titre d'exemple non limitatif, fera bien comprendre en quoi consiste l'invention et comment elle peut être réalisée.

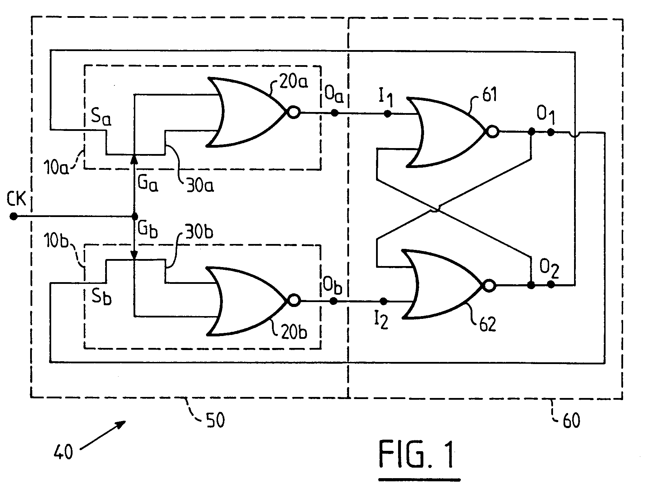

La figure 1 est le schéma d'une bascule pour diviseur de fréquence par 2 selon l'invention.

La figure 1 donne le schéma d'une bascule 40 pour diviser par 2 la fréquence d'un signal appliqué à une borne d'entrée CK, comprenant une bascule RS 60, connue en soi, constituée par une première 61 et une deuxième 62 portes NOR dont les premières entrées sont mutuellement intercouplées à leurs sorties O₁, O₂. Comme le montre la figure 1, la bascule 40 comprend également une troisième 20a et une quatrième 20b portes NOR dont les sorties Oa, Ob sont couplées, respectivement, aux entrées I₁, I₂ de la première 61 et de la deuxième 62 portes NOR de la bascule RS 60. D'autre part, les premières entrées des troisièmes 20a et quatrième 20b portes NOR sont couplées, respectivement, à la sortie O₂, O₁ de la seconde 62 et de la première 61 portes NOR via, respectivement, un chemin de conduction d'un premier 30a et d'un second 30b interrupteurs constitués par des transistors MESFET AsGa à enrichissement. Enfin, les secondes entrées de la troisième 20a et de la quatrième 20b portes NOR et l'entrée Ga, Gb des transistors 30a, 30b étant reliés à la borne d'entrée CK.

L'ensemble de la porte NOR 20a (respectivement 20b) et du transistor 30a (respectivement 30b) constitue un élément de mémoire 10a (respectivement 10b) du type maître-esclave avec remise à zéro de l'esclave. En effet, sur l'exemple de l'élément 10a :
- lorsqu'on applique en Ga un niveau logique 1, la sortie Oa est à O. Pendant cette opération, la capacité Cgs intrinsèque du transistor MESFET (jouant le rôle de maître), qui se trouve à la première entrée de la porte NOR 20a (jouant le rôle d'esclave), se charge et le niveau logique (E) de l'entrée Sa se retrouve ainsi sur la première entrée,
- lorsqu'on applique en Ga un niveau logique 0, on pince le transistor 30a, le niveau logique en Sa ne peut passer sur la première entrée. La porte NOR effectue son opération entre O et le niveau logique sur la première entrée, c'est à dire le niveau logique (E) qui existait en Sa lors de la phase précédente. On retrouve donc E à la sortie Oa de la porte NOR.

L'ensemble de la bascule de la figure 1 est réalisée avec des transistors MESFET à enrichissement, dont la tension de seuil V_{T} est de 0,2 V et la transconductance gₘ de 200 mS/mm. Ils fonctionnent avec un courant I_{DS} de 5,7 mA environ pour une largeur W de 100 µm et avec V_{GS}=0,7 V, V_{DS}=2 V et une longueur de grille de 0,7 µm.

Les deux transistors 30a et 30b ont une largeur de 5 µm. Les portes 20a, 20b sont constituées par des transistors de 1,5 µm de large et par une résistance de 3,5 kΩ. Les portes 61 et 62 sont composées de transistors de 20 µm de large et d'une résistance de 2,5 kΩ.

Bien qu'il n'a été fait mention dans ce texte que de transistors MESFET, d'autres types de transistors peuvent être envisagés, comme, par exemple, des transistors MOSFET ou bipolaires. De même, bien que le mode de réalisation décrit comprend des portes NOR et des MESFET à canal n, l'homme du métier serait capable de déduire les modes de réalisation correspondants comprenant des portes NAND.

## Revendications

1. Bascule pour diviser par 2 la fréquence d'un signal appliqué à une borne d'entrée (CK), comprenant d'une part une bascule RS (60) constituée par une première (61) et une deuxième (62) portes logiques dont les premières entrées sont mutuellement intercouplées à leurs sorties (O₁, O₂), et comprenant d'autre part une troisième (20a) et une quatrième (20b) portes logiques dont les sorties (Oa, Ob) sont couplées, respectivement aux entrées (I₁, I₂) de la première (61) et de la deuxième (62) portes logiques, dont les premières entrées sont couplées respectivement, à la sortie (O₂, O₁) de la deuxième (62) et de la première (61) portes logiques et dont les deuxièmes entrées sont reliées à ladite borne d'entrée (CK), caractérisée en ce que le couplage des premières entrées des troisième (20a) et quatrième (20b) portes logiques respectivement vers les sorties des deuxième (62) et première (61) portes logiques est effectué via un chemin de conduction d'un premier (30a) et d'un second (30b) interrupteurs, lesdits interrupteurs étant commandés à partir de la borne d'entrée.

2. Bascule selon la revendication 1, caractérisé en ce que chaque porte logique (61, 62, 20a, 20b) est une porte NOR, lesdits interrupteurs (30a, 30b) étant des transistors à effet de champ à enrichissement.

## Claims

1. A flip-flop for division by 2 of the frequency of a signal applied to an input terminal (CK), comprising on the one hand an RS flip-flop (60) which is formed by a first logic gate (61) and a second logic gate (62) whose first inputs are cross-coupled to their outputs (O₁, O₂), and comprising on the other hand a third logic gate (20a) and a fourth logic gate (20b) whose outputs (Oₐ, O_{b}) are coupled to the inputs (I₁, I₂) of the first logic gate (61) and the second logic gate (62), respectively, whose first inputs are coupled to the output (O₁, O₂) of the second logic gate (62) and the first logic gate (61), respectively, and whose second inputs are connected to said input terminal (CK), characterized in that the coupling of the first inputs of the third logic gate (20a) and the fourth logic gate (20b) to the outputs of the second logic gate (62) and the first logic gate (61), respectively, is realized via a conductive path of a first interrupter (30a) and a second interrupter (30b), respectively, said interrupters being controlled via the input terminal.

2. A flip-flop as claimed in Claim 1, characterized in that each logic gate (61, 62, 20a, 20b) is an NOR-gate, said interrupters (30a, 30b) being enhancement-type field effect transistors.

## Patentansprüche

1. Kippschaltung zum Halbieren der Frequenz eines einer Eingangsklemme (CK) zugeführten Signals, mit einerseits einem von einem ersten (61) und einem zweiten (62) Logikgatter gebildeten RS-Flipflop (60), deren erste Eingänge wechselseitig mit ihren Ausgängen (O₁, O₂) gekoppelt sind, und andererseits einem dritten (20a) und einem vierten (20b) Logikgatter, deren Ausgänge (Oₐ, O_{b}) jeweils mit den Eingängen (I₁, I₂) des ersten (61) und des zweiten (62) Logikgatters gekoppelt sind, deren erste Eingänge jeweils mit dem Ausgang (O₂, O₁) des zweiten (62) bzw. des ersten (61) Logikgatters gekoppelt sind und deren zweite Eingänge mit der genannten Eingangsklemme (CK) verbunden sind, dadurch gekennzeichnet, daß die Kopplung der ersten Eingänge des dritten (20a) und des vierten (20b) Logikgatters mit den Ausgängen des zweiten (62) bzw. ersten (61) Logikgatters über einen Leitungspfad eines ersten (30a) bzw. eines zweiten (30b) Schalters erfolgt, wobei die genannten Schalter von der Eingangsklemme aus betätigt werden.

2. Kippschaltung nach Anspruch 1, dadurch gekennzeichnet, daß jedes Logikgatter (61, 62, 20a, 20b) ein NOR-Gatter ist, wobei die Schalter (30a, 30b) Anreicherungs-Feldeffekttransistoren sind.
